# EUROPÄISCHE PATENTSCHRIFT

(11) **EP 3 894 260 B1**
(45) Veröffentlichungstag und Bekanntmachung des Hinweises auf die Patenterteilung: **29.03.2023**
(21) Anmeldenummer: 19829423.3
(22) Anmeldetag: 10.12.2019
(51) Int. Cl.: B60K 37/06, H03K 17/96, B29C 51/08, B29C 51/14, H05K 1/02, H05K 1/18, H05K 3/00

(54) **GEWÖLBTE FUNKTIONSFOLIENSTRUKTUR UND VERFAHREN ZUR HERSTELLUNG DERSELBEN**
CURVED FUNCTIONAL FILM STRUCTURE AND METHOD FOR PRODUCING SAME
STRUCTURE DE FEUILLE FONCTIONNELLE ARQUÉE ET SON PROCÉDÉ DE FABRICATION

(30) Priorität: 11.12.2018 DE 102018131760
(43) Veröffentlichungstag der Anmeldung: 20.10.2021
(73) Patentinhaber: Joanneum Research Forschungsgesellschaft mbH, 8010 Graz (AT); Hueck Folien GmbH, 4342 Baumgartenberg (AT); Scio Holding GmbH, 4030 Linz (AT)
(72) Erfinder: STADLOBER, Barbara, 8044 Graz (AT); BELEGRATIS, Maria, 8212 Pischelsdorf am Kulm (AT); SCHMIDT, Volker, 8212 Pischelsdorf am Kulm (AT); ZIRKL, Martin, 8200 Ludersdorf-Wilfersdorf (AT); SCHEIPL, Gregor, 8020 Graz (AT); TRASSL, Stephan, 4342 Baugartenberg (AT); GSCHWANDTNER, Andreas, 4020 Linz (AT); PADINGER, Franz, 4502 St. Marien (AT); HEILMANN, Michael, 4616 Weisskirchen/Traun (AT); IDE, Dirk, 4040 Linz (AT)
(74) Vertreter: Strehl Schübel-Hopf & Partner
(86) Internationale Anmeldenummer: PCT/EP2019/084345
(87) Internationale Veröffentlichungsnummer: WO 2020/120441

(56) Entgegenhaltungen:
- EP-A1- 3 168 715
- DE-A1-102014 013 564

## Beschreibung

### Gebiet der Erfindung

Die vorliegende Erfindung betrifft eine dreidimensional geformte Funktionsfolienstruktur mit einer Sensoreinheit und ein Verfahren zur Herstellung derselben.

### Stand der Technik

Derzeit werden Folienoberflächen im Bereich Structural Electronics, In-mold Elektronik und dreidimensional (3D) integrierter Elektronik häufig mit Funktionen versehen. Die Funktionsfolien werden dann in eine dreidimensionale Form gebracht oder in einem Foil Insertion Molding Prozess (FIM) hinterspritzt und damit mechanisch stabilisiert. Beispiele hierfür sind das europäische Projekt TERASEL1, in welchem mehrere FIM-Demonstratoren realisiert wurden, wie beispielsweise die 3D-Integration von LEDs auf einer dreidimensionalen Plastikkalotte bzw. eine Platte mit homogen beleuchteten Vertiefungen basierend auf integrierten LEDs. Außerdem gibt es auf dem Markt ein hinterspritztes LED-Display bzw. ein leuchtendes, flexibles Armband, wobei die LEDs erst auf dehnbaren Substraten mittels Pick&Place platziert und dann leicht verformt werden. Danach erfolgt die Übergießung und Stabilisierung in einem Spritzgussprozess unter Einsatz des Rolle-zu-Rolle-Verfahrens (R2R). Die Firmen Taktotek und plastic electronic beschäftigen sich ebenfalls mit smarter 3Dintegrierter Elektronik, wobei in beiden Fällen smarte Oberflächen für z.B. Bedienung von Haushaltsgeräten, Weißwaren, Automobilinterieur und Wearables vorgeschlagen werden. Dabei werden verschiedene kapazitive Schalter und Schieberegler auf flachen Foliensubstraten integriert, danach verformt und mittels Spritzgusses stabilisiert.

DE 10 2014 013564 A1 offenbart eine Funktionsfolienstruktur mit einer Wölbung, erhältlich durch ein Verfahren, welches das Bereitstellen einer Funktionsfolie, enthaltend ein Foliensubstrat und eine darauf angeordnete Sensoreinheit, die einen auf Druck- und/oder Temperaturänderung reagierenden Sensor und einen damit verbundenen Leiter aufweist, und das Formen der Wölbung in der Funktionsfolie in einem Bereich, der den Sensor und den Leiter zumindest teilweise enthält, umfasst.

EP 3 168 715 Al offenbart eine Verbundstruktur mit einem zwischen zwei Schichten eingebetteten Berührungssensor.

### Durch die Erfindung zu lösende Aufgaben

Der Stand der Technik offenbart jedoch keine Struktur, in der druck- oder temperatursensitive Tasten in eine dreidimensionale Form gebracht worden sind.

Daher ist es die Aufgabe der vorliegenden Erfindung, eine Struktur bereitzustellen, in der Funktionalitäten, z. B. optische, elektrische und/oder sensorische Funktionalitäten, auf einem dreidimensional geformten und vorzugsweise flexiblen Foliensubstrat aufgebracht sind.

Weitere Aufgaben der Erfindung sind, eine transparente, flexible Sensortaste auf einem Foliensubstrat mit folgenden Eigenschaften herzustellen: (i) Druck- bzw. Temperaturempfindlichkeit der Sensortaste, (ii) Teiltransparenz für Be- bzw. Hinterleuchtung der Taste durch entweder neben dem Sensor befestigte LEDs oder Wellenleiter zur Lichtverteilung entfernter LEDs, (iii) Verformbarkeit des bestückten und bedruckten Substrats durch thermische Umformprozesse wie z.B. Vakuumtiefziehen oder Hochdruckformen.

### Zusammenfassende Darstellung der Erfindung

Die Aufgabe wurde durch Bereitstellen einer Funktionsfolienstruktur gelöst, die eine Sensortaste auf einem Foliensubstrat angeordnet aufweist, wobei die Funktionsfolienstruktur durch thermische Umformprozesse wie z.B. Vakuumtiefziehen oder Hochdruckformen in eine dreidimensionale Form gebracht wird.

Der Gegenstand der vorliegenden Erfindung ist eine Funktionsfolienstruktur mit einer Wölbung, erhältlich durch ein Verfahren, das folgende Schritte umfasst:
(a) das Bereitstellen einer Funktionsfolie, enthaltend ein Foliensubstrat und eine darauf angeordnete Sensoreinheit, die einen auf Druck- und/oder Temperaturänderung reagierenden Sensor und einen damit verbundenen Leiter aufweist, wobei der Sensor ein Schichtsensor ist, der eine erste elektrisch leitfähige Schicht, eine Schicht aus einem ferroelektrischen Polymer und eine zweite elektrisch leitfähige Schicht in dieser Reihenfolge enthält, und
(b) das Formen der Wölbung in der Funktionsfolie in einem Bereich, der den Sensor und den Leiter zumindest teilweise enthält, wobei der Leiter und der Sensor gedehnt werden.

Weitere Gegenstände sind in den beigefügten Ansprüchen definiert.

Die Wölbung der erfindungsgemäßen Funktionsfolienstruktur weist also zumindest einen Teil des Sensors und einen Teil des Leiters auf, wobei der Teil des Sensors und der Teil des Leiters gedehnt werden.

Vorzugsweise ist der Sensor vollständig in dem gewölbten Bereich enthalten.

In einer bevorzugten Ausführungsform ist der Sensor vollständig in dem gewölbten Bereich enthalten und in z-Ebene um mindestens 3 mm aus der x-y-Ebene der Funktionsfolie heraus gewölbt.

Bevorzugt ist eine Struktur, wobei der Sensor vollständig in dem gewölbten Bereich enthalten ist und der Bereich mit dem Sensor mindestens 0,1 mm, bevorzugt mindestens 0,3 mm dicker als der dazu benachbarte Bereich ist.

### Vorteile der Erfindung

Die erfindungsgemäße Funktionsfolienstruktur weist einen Sensor in einer gewölbten Struktur auf. Dieser Aufbau hat gegenüber einem Sensor in einer planen Struktur den grundlegenden Vorteil, dass der Sensor exponiert ist und dadurch seine Empfindlichkeit erhöht oder seine Größe verringert werden kann, sowie eine haptische Struktur die Ertastbarkeit von Sensorelementen unterstützt. Beispielsweise ist ein Drucksensor in der exponierten gewölbten Struktur gegenüber Druckbeaufschlagung empfindlicher als ein Drucksensor in einer planen Fläche, wo die Druckbelastung teilweise auf die Gesamtfläche abgeleitet und dadurch verteilt wird.

Zudem ist in einer gewölbten Struktur die Gesamtoberfläche erhöht, so dass die Fläche des Sensors und damit seine Empfindlichkeit erhöht werden kann.

Die erfindungsgemäße Funktionsfolienstruktur ist für die Anwendung als Taste bzw. Tastenarray mit nahtloser Oberfläche in z.B. einer Bedienkonsole geeignet.

Die erfindungsgemäße Struktur weist eine hohe Druck- bzw. Temperaturempfindlichkeit der Sensortaste auf, welche auf verschiedene Tastendruckniveaus bzw. auf Personenannäherung reagieren und ein proportionales elektrisches Signal erzeugen.

Die in der vorliegenden Erfindung eingesetzten Folientastaturen weisen die üblichen Vorteile von Folientastaturen auf, nämlich eine geringe Verschmutzungsanfälligkeit, hohe Haltbarkeit, schnelle Anpassung des Designs und einen kostengünstigen und gut kontrollierbaren Herstellungsprozess.

Weitere Vorteile sind freies Design und freie Gestaltbarkeit im Sinne eines "Function follows Form"-Ansatzes, eine beliebige Sensorform, eine flache und leichte Sandwichbauweise, Transparenz sowie die Herstellung mittels massentauglicher Methoden wie beispielsweise Siebdruck, Schablonendruck und Pick&Place. Kabelbäume und komplizierte Assemblierung von Komponenten und Funktionseinheiten werden vermieden. Die Vorteile auf der Herstellerseite sind daher eine Kostenreduktion durch einfachere Herstellung und Montage und eine bessere Umweltbilanz durch verkürzte Lieferwege. Für den Benutzer sind eine intuitive Bedienung, geringeres Volumen und Gewicht, elegantes Design und einfache Reinigung der nahtlosen Bedienoberfläche von Vorteil.

Die erfindungsgemäße Struktur weist eine hohe Verformbarkeit des bestückten und bedruckten Substrats durch thermische Umformprozesse wie z.B. Vakuumtiefziehen oder Hochdruckformen auf.

In einer bevorzugten Ausführungsform ist die erfindungsgemäße Struktur teiltransparent für Be- bzw. Hinterleuchtung der Taste durch entweder neben dem Sensor befestigte LEDs oder Wellenleiter zur Lichtverteilung entfernter LEDs.

### Beschreibung der Figuren

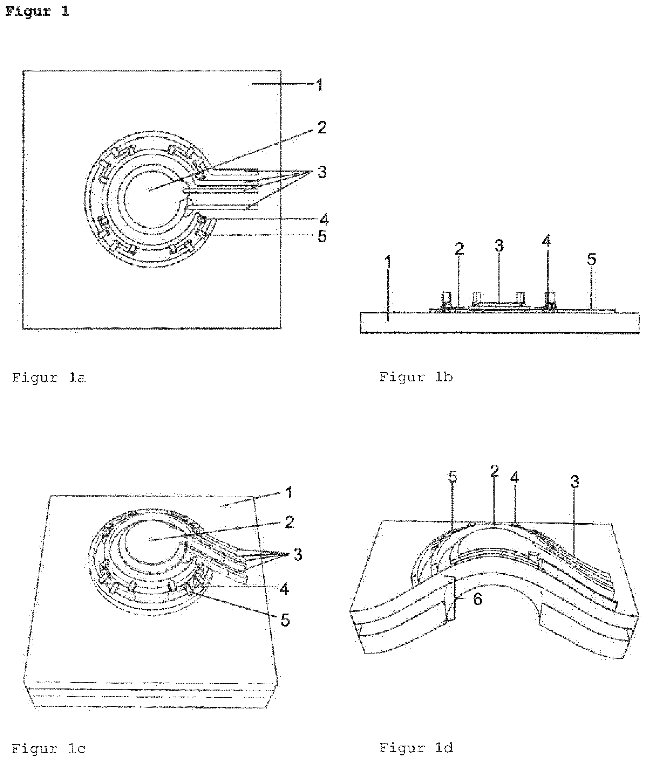

Figur 1 zeigt eine Ausführungsform der vorliegenden Erfindung. Bei dessen Herstellung wurde ein Funktionsmuster einer hinterleuchteten und dreidimensional geformten druckempfindlichen Sensortaste mit nahtloser Oberfläche hergestellt, wobei die Sensortaste zuerst auf einem flachen Substrat mit einem geeigneten Verfahren angebracht wird und danach mit einem geeigneten Verfahren dreidimensional verformt wird. Alle Funktionalitäten (optische, elektrische, sensorische) werden zuerst auf einem einzigen Foliensubstrat integriert, und anschließend erfolgt die Überführung in die dreidimensionale Form.
Figuren 1a) und 1b) zeigen die Funktionsfolienstruktur vor der Formung; Figuren 1c) und 1d) zeigen die Funktionsfolienstruktur nach der Verformung, also die erfindungsgemäße Funktionsfolienstruktur.
Figur 2 zeigt ein Schema einer hinterleuchteten druck- oder temperatursensitive Foliensensortaste, die eine dreidimensionale Form aufweist (z.B. Konsole) und zusätzlich noch Laminat, Streuschicht/Schmelzklebefolie und Konturfarbe besitzt.

### Ausführungsformen der Erfindung

Die erfindungsgemäße Funktionsfolienstruktur umfasst ein Foliensubstrat und eine darauf angeordnete Sensoreinheit. Mit anderen Worten ist die Sensoreinheit, vorzugsweise unmittelbar, auf der Oberfläche des Foliensubstrats aufgebracht.

Die erfindungsgemäße Funktionsfolienstruktur weist eine Sensoreinheit oder mehrere Sensoreinheiten auf. Sie dient damit der Messung von Änderungen in der Umgebung. Bei Anwesenheit von mehreren Sensoreinheiten können diese unterschiedliche Umgebungseigenschaften messen.

Der Sensor reagiert auf mindestens eine Änderung einer Umgebungseigenschaft, die aus der Gruppe ausgewählt ist, die aus Druck, Temperatur, Lichtstärke, Luftfeuchtigkeit oder Gaskonzentration besteht.

Vorzugsweise misst die Sensoreinheit einen Druckunterschied und/oder Temperaturunterschied, stärker bevorzugt beides.

Dieser externe Stimulus wird vorzugsweise in eine proportionale Ladungsmenge umgewandelt.

Vorzugsweise ist die Sensoreinheit auf der dreidimensional verformten, zusammenhängenden Oberfläche des Foliensubstrats integriert.

Die in der vorliegenden Erfindung verwendete Sensoreinheit, die einen Sensor und einen damit verbundenen Leiter enthält, ist hinsichtlich der Anzahl der Sensoren und der Leiter nicht eingeschränkt. Vielmehr kann die Sensoreinheit eine Vielzahl von Sensoren aufweisen. Jeder dieser Sensoren kann eine Vielzahl von Leitern aufweisen. Die Ausdrücke "ein Sensor" und "ein Leiter" bedeuten also "mindestens ein Sensor" bzw. "mindestens ein Leiter". Entsprechend stehen die Ausdrücke "enthält ... einen Sensor" und "enthält ... einen Leiter" oder sinngemäße Formulierungen also synonym für "enthält ... mindestens einen Sensor" bzw. "enthält ... mindestens einen Leiter". Diese gilt entsprechend auch für die anderen Elemente der erfindungsgemäßen Funktionsfolienstruktur, z. B. die Wölbung.

Der mit dem Sensor verbundene Leiter kann ein beliebiger Leiter sein. Er kann ein elektrischer Leiter sein und in der Form einer Leiterbahn vorliegen. Er kann auch ein optischer Leiter sein, z. B ein Wellenleiter zur Leitung von Licht von einer LED zu einem Sensor.

Der Sensor in der erfindungsgemäßen Funktionsfolienstruktur reagiert vorzugsweise auf Druckunterschiede zwischen 5 g (5 mbar für 1 cm² Fläche) und 1000 kg (1000 bar für 1 cm² Fläche), stärker bevorzugt 10 g bis 100 kg, und/oder auf Temperaturunterschiede von mindestens 0,1 K, stärker bevorzugt mindestens 0,2 K und am stärksten bevorzugt mindestens 0,5 K.

Die erfindungsgemäße Funktionsfolienstruktur weist eine flächige Struktur der Folie auf. Das heißt, die Länge in x-Richtung und die Breite in y-Richtung sind jeweils vorzugsweise um einen Faktor von mindestens 10, stärker bevorzugt mindestens 50, noch stärker bevorzugt mindestens 100 größer als die Dicke in z-Richtung. In der Funktionsfolienstruktur weisen vorzugsweise auch die Elemente also solche, zumindest das Foliensubstrat und zumindest der Sensor, vorzugsweise die gesamte Sensoreinheit, eine flächige Struktur gemäß der angegebenen Definition auf.

Die erfindungsgemäße Funktionsfolienstruktur hat eine Gesamtdicke der Funktionsfolie von vorzugsweise 20 µm bis 10 mm, stärker bevorzugt 50 µm bis 5 mm, noch stärker bevorzugt 100 µm bis 1 mm.

In bevorzugten Ausführungsformen ist die Dicke des Foliensubstrats 20 bis 1000 µm und die Dicke der Sensoreinheit 1 bis 100 µm, stärker bevorzugt ist eine Kombination aus einer Dicke des Foliensubstrats von 50 bis 500 µm und einer Dicke der Sensoreinheit von 1 bis 50 µm.

In einer bevorzugten Ausführungsform sind sowohl das Foliensubstrat als auch die Sensoreinheit thermoplastisch verformbar. Somit ist die ganze Funktionsfolie thermoplastisch verformbar.

In einer Ausführungsform weist die Funktionsfolienstruktur in dem Bereich mit Sensoreinheit und Leiter die gleiche Dicke auf wie der unmittelbar benachbarte Bereich ohne Sensoreinheit und Leiter. In dem Übergangsbereich sind die Dicken also durchgehend gleich. Sie können um höchstens 10 % oder weniger als 50 µm, weniger als 20 µm oder weniger als 10 µm voneinander abweichen. Dadurch kann man den Bereich der Sensoreinheit nicht ertasten.

In einer anderen Ausführungsform weist die Funktionsfolienstruktur in dem Bereich mit Sensoreinheit eine andere Dicke auf als der unmittelbar benachbarte Bereich ohne Sensoreinheit. Vorzugsweise handelt es sich bei dem Bereich mit Sensoreinheit um den Bereich des Sensors, stärker bevorzugt ausschließlich um den Bereich des Sensors, also ohne den Leiter oder sonstige benachbarte Strukturen. In dem Übergangsbereich sind die Dicken also unterschiedlich. Dabei kann der Bereich mit Sensor dicker oder dünner sein als der Bereich ohne Sensor. In beiden Fällen kann man somit den Bereich des Sensors ertasten. Die Dicken können sich vorzugsweise um 1 bis 2000 µm, stärker bevorzugt 10 bis 500 µm unterscheiden. Noch bevorzugter sind Unterschiede im Bereich von 50 bis 1000 µm, 100 bis 500 µm oder 50 bis 300 µm.

Der Ausdruck "Funktionsfolie" bezeichnet die erfindungsgemäße Funktionsfolienstruktur vor dem Formen, also vor dem Bilden der Wölbung.

Der Sensor, der auf Druckunterschiede und/oder Temperaturunterschiede reagiert, kann beispielsweise auf die Berührung mit einem Finger des Anwenders reagieren. Deshalb kann der Sensor auch als Schalter, Schaltelement oder Sensortaste bezeichnet werden.

Die erfindungsgemäße Funktionsfolienstruktur ist vorzugsweise flexibel oder weist vorzugsweise flexible Bereiche auf. Insbesondere ist es bevorzugt, dass der Bereich um die Sensortaste herum flexibel ist, damit diese bei Bedienung durch den Anwender, das heißt beim Drücken der Taste mit einem Finger, elastisch nachgibt. Daher sollte der Bereich, der die Sensortaste einschließt, flexibel sein. Dieser Bereich befindet sich vorzugsweise zumindest teilweise, stärker bevorzugt vollständig, in einem gewölbten Bereich. Die Flexibilität bzw. Nachgiebigkeit des Bereichs sollte vorzugsweise so sein, dass bei Raumtemperatur bei einer senkrechten Belastung der Sensortaste, die sich mittig in einem Probenstück der Funktionsfolienstruktur von 3 cm x 3 cm befindet, mit einem Gegenstand einer Masse von 100 g und einer Berührungsfläche von 1 cm² in Belastungsrichtung eine Verformung von mindestens 1 um, stärker bevorzugt mindestens 10 µm und noch stärker bevorzugt mindestens 50 µm erfolgt. Beispiele von bevorzugten Verformungsbereichen sind unter 1 bis 1000 µm, 10 bis 1000 µm, 50 bis 1000 µm, 1 bis 500 µm, 10 bis 500 µm oder 100 bis 500 µm ausgewählt.

Die erfindungsgemäße Funktionsfolienstruktur ist vorzugsweise selbsttragend. Das heißt, sie ist ohne Träger bei Raumtemperatur formstabil. Sie weist vorzugsweise keinen Träger auf.

Die erfindungsgemäße Funktionsfolienstruktur ist vorzugsweise selbsttragend, also ohne Träger, und flexibel bzw. weist flexible Bereich auf.

Sie ist also flächig und bevorzugt selbsttragend und flexibel.

Die erfindungsgemäße Funktionsfolienstruktur kann aber auch einen Träger aufweisen. Die Funktionsfolie kann nach dem Verformen auf einen Träger aufgebracht werden. Dadurch kann die Trägerstruktur genau an die Funktionsfolienstruktur angepasst werden. Alternativ kann der Träger eine Wölbung aufweisen, und Schritt (b) des erfindungsgemäßen Verfahrens kann ein Verformen der Funktionsfolie durch Aufbringen auf den gewölbten Träger sein. Auf diese Weise kann die Funktionsfolienstruktur genau an die Trägerstruktur angepasst werden.

Beim Verformen in Schritt (b) werden bevorzugt sowohl der Sensor als auch der Leiter gedehnt, wobei der Leiter ein elektrischer Leiter und/oder ein Lichtleiter sein kann.

Die erfindungsgemäße Funktionsfolienstruktur kann eine beliebige Form, beispielsweise in der Draufsicht ein kreisförmiges, elliptisches, quadratisches oder rechteckiges Design, aufweisen.

### Wölbung

Die erfindungsgemäße Funktionsfolienstruktur weist mindestens eine Wölbung und damit eine dreidimensionale Struktur auf.

Die Wölbung ist so definiert, dass die Funktionsfolie aus der x-y-Ebene an mindestens einem Punkt in z-Richtung um einen Wert verformt ist, der beispielsweise mindestens der 2-fachen Dicke der Funktionsfolie entspricht. Dieser Wert wird in der vorliegenden Erfindung als Wölbung "einer Höhe von mindestens Faktor 2" bezeichnet. Andere Beispiele einer Wölbung sind eine Höhe von mindestens Faktor 5, mindestens Faktor 10 oder mindestens Faktor 20. Der gewölbte Bereich ist in z-Richtung um vorzugsweise mindestens 1,0 mm, stärker bevorzugt mindestens 3,0 mm aus der umgebenden x-y-Ebene verformt.

Die erfindungsgemäße Funktionsfolienstruktur weist also bevorzugt in jeder Richtung x, y, und z einen Wert auf, der mindestens der 2-fachen, mindestens der 5-fachen, mindestens der 10-fachen oder mindestens der 20-fachen Dicke der Funktionsfolie entspricht.

In der vorliegenden Erfindung werden die Parameter x, y und z wie folgt ermittelt: Die Länge in x-Richtung und y-Richtung ergibt sich für eine Struktur beliebiger Form dadurch, dass sie in einen rechteckigen Rahmen kleinstmöglicher Fläche eingepasst wird und die Länge des Rahmens als x-Richtung und die Breite als y-Richtung angenommen wird. Die Höhe der Struktur ist die z-Richtung.

Die Krümmung der Wölbung in der erfindungsgemäßen Struktur ist vorzugsweise so stark, dass an mindestens einem Punkt an die Struktur eine Tangente so angelegt werden kann, dass sie sich auf einer gegebenen Strecke, z. B. 10 mm, um mindestens ein Zehntel dieser Strecke, also z. B. 1 mm, von der Tangente entfernt. Dieser Wert wird in der vorliegenden Erfindung als "Krümmung von mindestens 1/10" bezeichnet. In bestimmten Ausführungsformen ist die so definierte Krümmung mindestens 2/10, 5/10 oder 10/10.

Das Formen der Wölbung spiegelt sich in der Dehnung der Folie und der darin enthaltenen Bestandteile wider. Ein in der Folie enthaltener Leiter, beispielsweise eine elektrische Leitung, wird durch die Dehnung in der Draufsicht schmäler und/oder in der Querschnittsfläche kleiner. In einer Ausführungsform der Erfindung ist die Wölbung so stark, dass in der Wölbung ein Bereich vorhanden ist, wo ein und derselbe Leiter eine verringerte Querschnittsfläche und/oder in der Draufsicht eine verringerte Breite im Vergleich zu dem nicht gewölbten oder einem weniger gewölbten Bereich aufweist. Die Querschnittsfläche und/oder die Breite des Leiters ist auf einen Wert von höchstens 95 %, höchstens 90 %, höchstens 80 % oder höchstens 50 % der Querschnittsfläche und/oder Breite im nicht gewölbten oder einem weniger gewölbten Bereich verringert.

Die Verringerung der Querschnittsfläche und/oder der Breite des Leiters ist in einem gegebenen Bereich einer Wölbung vorzugsweise proportional zum Ausmaß der Verformung. Das heißt, dass in einem stark gekrümmten Bereich der Wölbung der Leiter entsprechend stark gedehnt wird und folglich seine Breite in der Draufsicht und/oder seine Querschnittsfläche entsprechend stark verringert wird.

Entsprechendes gilt nicht nur für den Leiter, sondern auch für die anderen dehnbaren Elemente der Funktionsfolienstruktur, z. B. den Sensor.

Außerdem zeigen sich in der Wölbung vermehrt Mikrorisse in dem Leiter. Das heißt, die Anzahl der Mikrorisse im gewölbten Bereich ist höher als im nicht gewölbten oder einem weniger gewölbten Bereich.

Ein weiteres Merkmal der Wölbung ist die unterschiedliche Struktur der Polymere im Vergleich zum nicht gewölbten Bereich oder einem weniger gewölbten Bereich. Ein Unterschied ist beispielsweise die Kristallstruktur der Polymere im Foliensubstrat und/oder im Sensorelement.

In der vorliegenden Erfindung schließt der Ausdruck "Dehnung" bzw. "dehnen" das bloße Biegen, Knicken oder Falten einer Struktur aus. Vorzugsweise sind in der Wölbung der Funktionsfolienstruktur sowohl der Sensor bzw. die Sensoren als auch der damit verbundene bzw. die damit verbundenen Leiter gedehnt.

Die Wölbung weist in einer Ausführungsform mindestens einen Bereich auf, wo mindestens ein Element der Struktur, vorzugsweise der Leiter, im Vergleich zum nicht gewölbten oder einem weniger gewölbten Bereich um mindestens 5 %, mindestens 10 %, mindestens 20 % oder mindestens 30 % gedehnt ist.

In einer bevorzugten Ausführungsform hat die erfindungsgemäße Funktionsfolienstruktur eine Dicke von mindestens 0,05 mm, eine Länge und Breite von mindestens je 1 cm, eine Wölbung einer Höhe von mindestens Faktor 2 und eine Krümmung von mindestens 1/10.

In einer weiteren bevorzugten Ausführungsform hat die erfindungsgemäße Funktionsfolienstruktur eine Dicke von mindestens 0,1 mm, eine Länge und Breite von mindestens je 3 cm, eine Wölbung einer Höhe von mindestens Faktor 4 und eine Krümmung von mindestens 2/10.

In einer weiteren Ausführungsform hat die erfindungsgemäße Funktionsfolienstruktur eine Dicke von 0,05-10 mm, eine Länge und Breite von je 1-100 cm, eine Wölbung einer Höhe von mindestens Faktor 2 und eine Krümmung von mindestens 1/10.

In einer weiteren bevorzugten Ausführungsform hat die erfindungsgemäße Funktionsfolienstruktur eine Dicke von 0,1-2 mm, eine Länge und Breite von je 3-20 cm, eine Wölbung einer Höhe von mindestens Faktor 4 und eine Krümmung von mindestens 2/10.

Die erfindungsgemäße Funktionsfolienstruktur kann eine oder mehrere Wölbungen aufweisen. Die mehreren Wölbungen können zusammenhängend sein, oder sie können unabhängig voneinander sein, so dass sie durch Bereiche getrennt sind, wo das Foliensubstrat nicht verformt ist.

### Foliensubstrat

Das Foliensubstrat dient als Träger für die Sensoreinheit.

Es trägt vorzugsweise alle elektrischen Bauteile der erfindungsgemäßen Funktionsfolienstruktur.

Das Foliensubstrat ist vorzugsweise flexibel. Die Flexibilität ist so definiert, dass bei Raumtemperatur bei einer senkrechten Belastung eines Probenstücks des Foliensubstrats von 3 cm x 3 cm mit einem Gegenstand einer Masse von 100 g und einer Berührungsfläche von 1 cm² in Belastungsrichtung eine elastische Verformung von mindestens 1 um, stärker bevorzugt mindestens 10 µm und noch stärker bevorzugt mindestens 50 µm erfolgt. Beispiele von bevorzugten elastischen Verformungsbereichen sind unter 1 bis 1000 µm, 10 bis 1000 µm, 50 bis 1000 µm, 1 bis 500 µm, 10 bis 500 µm oder 100 bis 500 µm ausgewählt.

Als Foliensubstrate kommen beispielsweise Trägerfolien, vorzugsweise flexible Kunststofffolien, beispielsweise aus PI (Polyimid), PP (Polypropylen), PMMA (Polymethylmethacrylat), MOPP (monoaxial verstreckte Folie aus Polypropylen), PE (Polyethylen), PPS (Polyphenylensulfid), PEEK (Polyetheretherketon), PEK (Polyetherketon), PEI (Polyethylenimin), PSU (Polysulfon), PAEK (Polyaryletherketon), LCP (flüssigkristalline Polymere), PEN (Polyethylennaphthalat), PBT (Polybutylenterephthalat), PET (Polyethylenterephthalat), PA (Polyamid), PC (Polycarbonat), COC (Cycloolefin-Copolymer), POM (Polyoxymethylen), ABS (AcrylnitrilButadien-Styrol-Copolymer), PVC (Polyvinylchlorid), PTFE (Polytetrafluorethylen), ETFE (Ethylentetrafluorethylen), PFA (Tetrafluorethylen-Perfluorpropylvinylether-Fluorcopolymer), MFA (Tetrafluor-methylen-Perfluorpropylvinylether-Fluorcopolymer), PTFE (Polytetra-fluorethylen), PVF (Polyvinylfluorid), PVDF (Polyvinylidenfluorid), und EFEP (Ethylen-Tetrafluorethylen-Hexafluorpropylen-Fluorterpolymer) in Frage.

Das Foliensubstrat kann einschichtig oder mehrschichtig sein. Ein einschichtiges Substrat kann aus einem der genannten Materialien bestehen, beispielsweise aus PET, PC, PA, PMMA, oder PI.

Ein mehrschichtiges Foliensubstrat ist vorzugsweise ein Folienverbund. Dieses kann beispielsweise aus einer Materialkombination aus den oben angeführten Materialien bestehen.

Die Folie bzw. der Folienverbund weist eine flächige Struktur auf. Das heißt, die Länge in x-Richtung und die Breite in y-Richtung sind jeweils vorzugsweise um einen Faktor von mindestens 10, stärker bevorzugt mindestens 50, noch stärker bevorzugt mindestens 100 größer als die Dicke in z-Richtung.

In EP 2 014 440 A1 werden hinterspritzbare Folien bzw. bahnförmige Laminate aus einer Dekorfolie und einer Trägerfolie beschrieben. Dekorfolie und Trägerfolie sind durch ein 2-Komponenten-Klebesystem verbunden. Die Dekorfolie kann vorzugsweise aus PMMA, PC, PS, PET oder ABS, PP, PU bestehen. Die Dicke der Dekorfolie beträgt etwa 6 bis 500 um. Die Trägerfolie kann aus gleichem oder unterschiedlichem Material bestehen wie die Dekorfolie. Die Dicke der Trägerfolie beträgt etwa 50 - 800 um, vorzugsweise 150 - 500 um.

In WO 2016/042414 A2 wird ein Verfahren zur Herstellung eines umgeformten Schaltungsträgers in Form eines Laminats aus Haftvermittlerfolie, ggf. Kleberschicht, Schaltungsträgerfolie und rein metallischer Leiterbahn beschrieben.

Die Herstellung des Folienverbundes kann wie folgt durchgeführt werden: Das flächige Verbinden des Foliensubstrats (z.B. PEN) und der Trägerfolie (z.B. ABS) kann mittels eines Nasskaschiervorgangs in einem Rolle-zu-Rolle-Verfahren erfolgen. Beim Kaschiervorgang wird zunächst ein flüssiger Kaschierkleber auf eine der beiden Folien aufgetragen, ggf. vorgetrocknet und die so beschichtete Folie anschließend unter Einwirkung von Druck und/oder Temperatur mit der anderen Folie verbunden. Es können beispielsweise Kaschierkleber auf Wasser oder auf Lösemittelbasis verwendet werden. Zur Erhöhung der Beständigkeit der Kaschierung werden bevorzugt 2-komponentige Kaschierkleber eingesetzt. Alternativ können UV-härtende Kaschierkleber verwendet werden. Der Kaschierkleber kann beispielsweise durch Lackieren, durch bekannte Druckverfahren, wie Flexodruck-, Tiefdruck-, Offsetdruckverfahren, Curtain Coating, durch Sprühen, durch Rakeln und dergleichen aufgebracht werden.

### Sensor oder Folientastatur

Der Sensor bzw. die Folientastatur hat vorzugsweise eine flächige Struktur. Vorzugsweise weist die gesamte Sensoreinheit eine flächige Struktur auf.

Flächig heißt, dass die Länge in x-Richtung und die Breite in y-Richtung sind jeweils vorzugsweise um einen Faktor von mindestens 10, stärker bevorzugt mindestens 50, noch stärker bevorzugt mindestens 100 größer als die Dicke in z-Richtung.

Der Sensor bzw. die Folientastatur ist vorzugsweise flexibel.

Folientastaturen bestehen herkömmlich aus Drucktasten, die meistens einen elektrischen Kontakt zwischen der Oberfläche mit aufgedruckten Tastensymbolen und einem darunter befindlichen Schaltkreis herstellen.

Es gibt eine Technologie, die die intuitive Bedienung von mobilen elektronischen Funktionsfolienstrukturen (z.B. Fernbedienung von Industrierobotern) mittels drucksensitiver Sensortasten an Stelle von Drehreglern, Tastern und Schaltern ermöglicht. Die intuitive Bedienung bedeutet in diesem Zusammenhang, dass die Taste eine Signalhöhe erzeugt, die der Höhe des aufgebrachten Tastendrucks proportional ist. Damit wirkt die Taste als analoge Taste und nicht als reiner Ein-Aus-Schalter. Diese Tasten basieren auf der PyzoFlex^{®} Sensortechnologie. Die Technologie basiert auf Sensoren aus speziellen Polymeren, welche lokale Druck- und Temperaturänderungen hochpräzise erfassen können. In dieser Technologie werden sowohl der pyroelektrische Effekt als auch der piezoelektrische Effekt genutzt. Ein Sensorelement besteht aus einer gepolten, zwischen zwei gedruckten Elektroden eingebetteten, ferroelektrischen Polymerschicht und bildet somit ein kapazitives Element. Diese Polymerschicht enthält ferroelektrische Kristallite, deren elektrisches Dipolmoment durch Polung in einem elektrischen Feld ausgerichtet werden kann. Nach dieser Polungsaktivierung werden in der Sensorschicht durch kleinste Druck- oder Temperaturänderungen elektrische Ladungen erzeugt, die zu den Elektroden fließen und als Spannungssignale, Stromsignale oder Ladungsmenge ausgelesen werden können. Die detektierte Signalhöhe ist dabei proportional zur Stärke bzw. Geschwindigkeit der Berührung. Das heißt, es kann nicht nur erfasst werden wo berührt wird, sondern auch wie stark und wie schnell. Die Materialbasis bilden ferroelektrische Co-Polymere aus der PVDF-Klasse. Mit den großflächig druckbaren Sensoren der PyzoFlex^{®}-Technologie werden die durch Berührung entstehenden Deformationen der aktiven Schicht über den piezoelektrischen Effekt in elektrische Energie umgewandelt (Piezogeneratoren), auf der Bedienfläche lokalisiert und deren Druckkraft quantifiziert. Diese Sensoren können mittels Siebdruckverfahrens auf flexiblen Oberflächen sehr kostengünstig hergestellt werden. Überall wo Druck- und Temperaturänderungen, Schwingungen, und Stoßwellen auftreten, können Piezogeneratoren die mechanischen Deformationen (Dickenänderungen) und Pyrogeneratoren die Temperaturunterschiede in elektrische Energie umwandeln, um als energieeffiziente analoge Tasten zu fungieren. Als Materialbasis der PyzoFlex^{®}-Technologie kann dabei ein ferroelektrisches CoPolymer (P(VDF-TrFE), Polyvinylidenfluorid-Trifluorethylen) dienen, welches zwischen gedruckten Elektrodenebenen eingebettet ist und nach einer elektrischen Polung starke piezo- und pyroelektrische Aktivität zeigt, eine hohe chemische Robustheit aufweist, sehr UVbeständig und witterungsfest, sowie schwer entflammbar ist.

Als Elektroden können elektrisch leitfähige Polymere, wie PEDOT:PSS (PEDOT:PSS: Poly(3,4-ethylenedioxythiophen) polystyrolsulfonat), oder Carbon eingesetzt werden.

Poly-3,4-ethylendioxythiophen (PEDOT) ist ein elektrisch leitfähiges Polymer auf Thiophenbasis.

Die PVDF-TrFE Sensoren sind in der Lage, Druckunterschiede (typischerweise zwischen wenigen Gramm und mehreren Kilogramm) zu erkennen. Je nach (anwendungsspezifischer) Elektronik und Anzahl der verwendeten Sensoren können diese hochfrequent abgetastet werden, wodurch schnelle Reaktionszeiten und eine flüssige Interaktion ermöglicht werden.

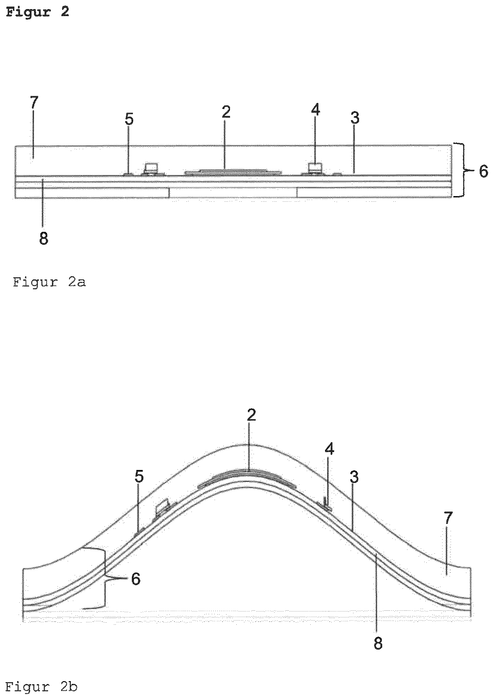

Die Herstellung der Foliensensortasten kann beispielsweise wie folgt durchgeführt werden: Die einzelnen Schichten der Foliensensortaste (Sensorsandwich, Leiterbahnen) und die Dekorfarbe wurden mittels additiven Siebdruckverfahren inkl. Zwischentrocknung durch eine Maske (Sieb/Schablone) auf einen vorgeschnittenen Folienverbund (z.B. PEN/ABS) strukturiert aufgebracht. Die Druckreihenfolge ist wie folgt: Auf der bedruckbaren PEN-Seite des Folienverbundes wird erst eine PEDOT:PSS Schicht für die Grundelektroden (Schichtdicke 1 µm) gedruckt, dann die ferroelektrische Sensorschicht (Schichtdicke 10 µm), dann werden die PEDOT:PSS Deckelektroden (Schichtdicke 1 um), dann eine Carbonschicht (Schichtdicke 1-3 µm) als leitende Diffusionssperre und schließlich elektrische Leiterbahnen (z.B. aus Silber) (beispielsweise mit Breite 2 mm) für die Kontaktierung nach außen aufgetragen. Außerdem wird in allen Bereichen außerhalb des semitransparenten Tastenbereichs (siehe Figur 2) eine schwarze, und daher gut absorbierende, nichtleitende Dekorfarbe/Konturfarbe aufgedruckt, bevorzugt auf die Rückseite des Folienverbundes (ABS). Zwischen den Druckschritten wird bei 60-65°C ausgeheizt. Generell muss darauf geachtet werden, dass alle gedruckten Materialien auch bei der Erwärmung während des Verformungsprozesses eine gute Haftung zu der jeweilig darunterliegenden Struktur behalten, sowie eine genügende Dehnbarkeit für die Verformung aufweisen.

Der in der vorliegenden Erfindung eingesetzte Sensor weist einen Schichtaufbau (Sandwichaufbau) auf (Schichtsensor). Dieser umfasst eine erste elektrisch leitfähige Schicht, eine Schicht aus einem ferroelektrischen Polymer und eine zweite elektrisch leitfähige Schicht in dieser Reihenfolge.

Die elektrisch leitfähigen Schichten können als Elektrodenschichten oder Elektroden bezeichnet werden.

Die ferroelektrische Poymerschicht kann ein, vorzugsweise druckbares, PVDF-TrFE-Copolymer sein. Darin kann das Molverhältnis PVDF:TrFE beispielsweise 50:50 bis 85:15, bevorzugt 70:30 bis 80:20 sein.

Die ferroelektrische Poymerschicht kann ein, vorzugsweise druckbares, PVDF-TrFE-CFE- oder PVDF-TrFE-CTFE-Terpolymer sein. Darin kann das Molverhältnis PVDF:TRFE:CFE vorzugsweise 50-75:20-40:5-10, beispielsweise 62.6:29.4:8, oder PVDF:TRFE:CTFE vorzugsweise 50-75:20-40:5-10, beispielsweise 61.6:29.4:9 sein.

In der vorliegenden Erfindung werden folgende Abkürzungen verwendet: PVDF: Polyvinylidenfluorid; TrFE: Trifluorethylen; CFE: Chlorfluorethylen.

Die ferroelektrische Polymerschicht kann auch ein, vorzugsweise druckbares, PVDF-TrFE-Nanokompositmaterial sein. Dieses kann in eine PVDF-TrFE-Matrix eingemischte anorganische ferroelektrische Nanopartikel enthalten oder aus diesen bestehen. Diese Nanopartikel können SrTi0₃ (Strontiumtitanat), PbTi0₃ (Bleititanat), PbZrTi0₃ (Bleizirkoniumtitanat), BaTi0₃ (Bariumtitanat) oder BNT-BT (Bismutnatriumtitanat-Bariumtitanat) sein. Das Nanokompositmaterial kann in der ferroelektrischen Polymerschicht in einem Volumenanteil (Füllgrad) von 5 und 50 %, bevorzugt 10 und 35 % enthalten sein.

Die Elektroden können aus einem, vorzugsweise druckbaren, leitfähigen Material bestehen und können PEDOT-PSS, Kohlenstoff, Silber, Aluminium, Chrom, Gold oder Kupfer enthalten oder aus diesen bestehen. Die Elektroden können aus einem aus der Vakuumphase abscheidbaren Metall wie beispielsweise Al, Cu, Au, Ag oder Chrom bestehen.

In einer bevorzugten Ausführungsform sind sowohl die elektrisch leitfähigen Schichten als auch die ferroelektrischen Schichten des Schichtsensors druckbar.

Diese Schichtstruktur ist vorzugsweise thermisch verformbar. Die maximale Dehnung bei der Verformung im Vergleich zum nicht oder einem weniger verformten Bereich beträgt mindestens 5 %, mindestens 10 %, mindestens 20 % oder mindestens 30 %.

Stärker bevorzugt sind die Schichten des Schichtsensors sowohl druckbar als auch thermisch verformbar.

Noch stärker bevorzugt sind sowohl die Schichten des Schichtsensors als auch die Leiter druckbar und thermisch verformbar. Dazu ist die maximale Dehnung dieser Elemente bei der Verformung im Vergleich zum nicht oder einem weniger verformten Bereich mindestens 5 %, mindestens 10 %, mindestens 20 % oder mindestens 30 %.

### Leiter

Der mit dem Sensor verbundene Leiter kann ein beliebiger Leiter sein.

Er kann ein elektrischer Leiter sein und in der Form einer Leiterbahn vorliegen. Er kann auch ein optischer Leiter sein, z. B ein Wellenleiter zur Leitung von Licht von einer LED zu einem Sensor.

Der Leiter bzw. die Leiterbahn ist vorzugsweise druckbar und/oder kann durch bekannte Verfahren zur Herstellung von partiellen Metallschichten beispielsweise Bedampfen, Sputtern, Walzenauftragsverfahren, Sprühen, Galvanisieren und dergleichen aufgebracht werden. Eine partielle Metallisierung kann durch partielle Metallisierungsverfahren, wie partiellen Auftrag einer hochpigmentierten Farbe vor dem Metallisierungsvorgang und Ablösen dieser Farbschicht gemeinsam mit der darauf aufgebrachten Metallschicht, durch Verwendung einer Maske, durch Ätzvorgänge oder Laserabtrag und dergleichen erfolgen.

Die gedruckten Leiterbahnen enthalten in einer Ausführungsform Kupfer oder Silber oder bestehen daraus. Vorzugsweise bestehen sie im Wesentlichen aus Cu oder Ag, das heißt, sie enthalten mindestens 90 Gew.-%, vorzugsweise mindestens 95 Gew.-% Cu oder Ag.

### Leitfähiger Kleber

In der vorliegenden Erfindung kann ein leitfähiger Kleber eingesetzt werden, um beispielsweise SMD-Bauteile aufzukleben.

SMD-Bauteile (SMD = surface-mounted device) sind oberflächenmontierte Bauteile.

Herkömmlich erfolgt bei der Bauteilbestückung die Verlötung mittels ROHS-konformer Lotpaste. Das Anhaften mittels Leitkleber ist nicht üblich.

Der leitfähige Kleber kann so ausgewählt sein, dass mit geringeren Temperaturen eine elektrisch leitfähige Verbindung hergestellt werden kann. Da der Aushärteprozess des Leitklebers im Bereich 120°C oder darunter liegt, ermöglicht diese Art der Bauteilbestückung die Verwendung von temperatursensiblen Substraten, wie beispielsweise PET, PC oder PMMA, sowie Laminaten daraus und vergrößert das Anwendungsspektrum von elektronischen Bauteilen enorm. Anzumerken ist, dass die Haftkräfte beim leitfähigen Kleben geringer sind als bei der konventionellen Verlötung, was wiederum die Einsatzbereiche einschränken würde, vor allem wenn es zu starken Vibrationen kommt.

Der Leitkleberauftrag und die SMD-Bestückung können wie folgt durchgeführt werden: Mittels Schablone wurde ein isotrop leitfähiger Kleber (MG-8331S bzw. eine modifizierter, mit Ag-Nanopartikeln gefüllter Acrylatkleber) strukturiert aufgetragen, sodass nur jene Punkte mit Kleber beschichtet werden, welche für die Kontaktierung der Bauteile notwendig sind. In die nasse Klebermasse wurden im Anschluss die SMD-Bauteile (LEDs und Vorwiderstände) per Pick&Place-Automat positioniert. Die elektrische Kontaktierung der Bauteile an die Folie erfolgte durch Aushärtung des Klebers in einem Trockenschrank.

Vorteil des leitfähigen Klebens ist die aufgrund der niedrigeren Temperaturen einsetzbare Vielfalt an temperatursensiblen Substratmaterialien.

In der vorliegenden Erfindung ist mindestens ein Teil, vorzugsweise die Gesamtheit der elektrischen Bauteile, vorzugsweise mit einem leitfähigen Kleber auf das Foliensubstrat geklebt.

### Verformungstoleranter Lack

Bei der konventionellen Bestückung mit ROHS konformer Lotpaste wird aufgrund der genügenden Haftkraft der Verlötung und aufgrund der starren Substrateigenschaften kein verformungstoleranter Schutzlack benötigt.

Die Haftkräfte bei leitfähiger Verklebung sind im Vergleich zur konventionellen Verlötung geringer, was im Laufe der Zeit bei mechanischer Beanspruchung der Elektronikfolie zu einem Ablösen der Bauteile von den Leiterbahnen oder zu einer Unterbrechung des elektrischen Kontakts zwischen Bauteil und Leiterbahn führen könnte. Um dem entgegenzuwirken, können die Bauteile nach der elektrisch leitfähigen Verklebung mit einem elektrisch nicht leitfähigen Schutzlack umhüllt werden, welcher beim Auftrag vorzugsweise auch unter das Bauteil eingesogen wird. Derart wird die mechanische Festigkeit zwischen Bauteil und Trägerfolie maßgeblich verstärkt, was zu mit konventioneller Verlötung vergleichbaren Haftkräften führt. Gleichzeitig erfolgt durch den Schutzlack neben dem mechanischen auch ein elektrischer Schutz.

Da die Funktionsfolien mechanisch flexibel sind und auch dreidimensional verformt werden, ist bei der Auswahl des Schutzlackes auf Verformungstoleranz auch im ausgehärteten Zustand zu achten. Eine Versprödung wurde zu Haarrissen und in der Folge zum Abriss der elektrischen Kontaktierung zwischen Leiterbahn und Bauteil führen.

Zur Verstärkung der Haftungseigenschaften der SMD-Bauteile auf der Folie können diese zusätzlich lokal mit einem niederviskosen Lack fixiert werden. Der Auftrag des Lackes erfolgt beispielsweise mittels Dispenser punktuell oder vollflächig per Sprühverfahren. Aufgrund der hohen Kriecheigenschaften des Lackes fließt dieser auch in den Zwischenraum zwischen der Bauteilunterseite und dem Substrat. Hierdurch wird die Haftung der Bauteile zur Oberfläche maximiert.

In der vorliegenden Erfindung sind die elektrischen Bauteile, die mit einem leitfähigen Kleber auf das Foliensubstrat geklebt sind, vorzugsweise mit einem Lack überzogen, der vorzugsweise verformungstolerant ist. Ein Beispiel eines solchen Lacks ist NoriCure^{®}MPF.

### Klebefolie

Für einen verbesserten Schutz der Bauteile beim Verformen kann nach dem Bestücken des Foliensubrates auf den verformungstoleranten Schutzlack noch eine Klebefolie aufgebracht werden. Die Klebefolie kann dabei die elektronischen Bauteile vor mechanischen Belastungen beim Verformen und Hinterspritzen schützen und/oder als Streuelement für eine homogene Ausleuchtung dienen und/oder als Haftvermittler für eine gute Anbindung an Spritzgut fungieren. Die Klebefolie kann vorzugsweise aus einem mehrschichtigen Aufbau aus Schmelzklebestoff (beispielsweise auf Basis von PA, PE, APAO, EVAC, TPE-E, TPE-U, TPE-A) und Streufolie bestehen. Danach kann die ungeformte Funktionsfolie auf das Verformungswerkzeug beispielsweise mit Lasercutter zugeschnitten werden. Die Klebefolie kann eine Schmelzklebefolie sein.

Schmelzklebstoffe, auch, Hotmelt genannt, sind lösungsmittelfreie und bei Raumtemperatur mehr oder weniger feste Produkte, die im heißen Zustand auf die Klebefläche aufgetragen werden und beim Abkühlen eine feste Verbindung herstellen. Die Vorteile eines Schmelzklebestoffes sind u.a. dass die Verklebung verschiedenster Materialien möglich ist, sie ist also auch geeignet für poröse Werkstoffoberflächen und kann Unebenheiten der verklebten Oberflächen ausgleichen. Außerdem weist die Klebefuge eine große Elastizität auf.

In der vorliegenden Erfindung ist eine Ausführungsform bevorzugt, in der elektrische Bauteile mit einem leitfähigen Kleber auf das Foliensubstrat geklebt sind, diese Bauteile mit einem vorzugsweise verformungstoleranten Lack überzogen sind und diese Bauteile und der Lack mit einer Klebefolie, vorzugsweise einer Schmelzklebefolie, überzogen ist.

Die erfindungsgemäße Funktionsfolienstruktur weist also vorzugsweise ein Foliensubstrat, einen leitfähigen Kleber, elektrische Bauteile, einen Lack und eine Klebefolie in dieser Reihenfolge aus.

Die erfindungsgemäße Funktionsfolienstruktur weist neben den Schichtsensoren besonders bevorzugt ein Foliensubstrat, einen leitfähigen Kleber, elektrische Bauteile, einen Lack und eine Klebefolie in dieser Reihenfolge aus. Dieser Schichtaufbau ohne Sensoren wird als Bauteilebefestigungsstruktur bezeichnet.

Wie vorstehend beschrieben wurde, ist der Sensor in der erfindungsgemäßen Funktionsfolienstruktur ein Schichtsensor, umfassend eine erste elektrisch leitfähige Schicht, eine Schicht aus einem ferroelektrischen Polymer und eine zweite elektrisch leitfähige Schicht in dieser Reihenfolge.

Eine besonders bevorzugte Ausführungsform der erfindungsgemäßen Funktionsfolienstruktur enthält auf dem Foliensubstrat sowohl eine Bauteilebefestigungsstruktur, umfassend einen leitfähigen Kleber, elektrische Bauteile, einen Lack und eine Klebefolie in dieser Reihenfolge, als auch einen mit dem Schichtaufbau über Leiter verbundenen Schichtsensor, umfassend eine erste elektrisch leitfähige Schicht, eine Schicht aus einem ferroelektrischen Polymer und eine zweite elektrisch leitfähige Schicht in dieser Reihenfolge.

Die Klebefolie ist vorzugsweise eine Schmelzklebefolie.

Die Klebefolie bzw. Schmelzklebefolie bedeckt in einer Ausführungsform auch den Schichtsensor.

Die in der Bauteilebefestigungsstruktur enthaltenen Bauteile sind vorzugsweise SMD-Bauteile.

Die Sensoreinheit kann auch einen oder mehrere Vorwiderstände umfassen. Diese können druckbar sein und leitfähige Materialien enthalten oder aus diesen bestehen. Ein Vorwiderstand kann ein SMD-Bauteil sein und/oder kann durch einen leitfähigen Kleber auf dem Foliensubstrat befestigt sein. Der befestige Vorwiderstand kann mit Schutzlack oder Fixierlack überzogen werden.

In einer Ausführungsform ist der Sensor, das lichtemittierende Element und/oder der Vorwiderstand über gedruckte Leiterbahnen nach außen angeschlossen oder kontaktiert ein außerhalb angeordnetes elektrisches Element.

Die erfindungsgemäße Funktionsfolienstruktur kann eine Schutzfolie aufweisen, die über den elektrischen Bauteilen, über dem Sensor, dem lichtemittierenden Element und den Vorwiderständen vorzugsweise als Schmelzklebefolie angeordnet ist.

Es wird angemerkt, dass die hier beschriebene Bauteilebefestigungsstruktur auf dem Foliensubstrat eine eigene Erfindung darstellen kann, also unabhängig von den sonstigen Elementen der Funktionsfolienstruktur ist. Das heißt, ein Aufbau, umfassend eine hierin beschriebene Bauteilebefestigungsstruktur auf einem Foliensubstrat, mit einer wie in dieser Anmeldung definierten Wölbung ist eine separate Erfindung und könnte unabhängig beansprucht werden.

Diese Erfindung ist wie folgt definiert:
Funktionsfolienstruktur mit einer Wölbung, erhältlich durch ein Verfahren, das folgende Schritte umfasst:
(a) das Bereitstellen einer Funktionsfolie, umfassend ein Foliensubstrat und eine darauf angeordnete Bauteilebefestigungsstruktur, die einen leitfähigen Kleber, elektrische Bauteile und einen Lack in dieser Reihenfolge aufweist, und
(b) das Formen einer Wölbung in der Funktionsfolie in einem Bereich der Bauteilebefestigungsstruktur, wobei mindestens der leitfähige Kleber und der Lack gedehnt werden.

Diese Funktionsfolienstruktur kann zudem eine Klebefolie über der Bauteilebefestigungsstruktur zum Kleben an das Foliensubstrat umfassen, wobei beim Verformen auch die Klebefolie gedehnt wird.

### Transparenz

Die erfindungsgemäße Funktionsfolienstruktur kann transparente Bereiche aufweisen. Vorzugsweise ist die gesamte Funktionsfolienstruktur transparent.

Die Transparenz des Schichtaufbaus ist vorzugsweise mindestens 60 %, stärker bevorzugt mindestens 70 %, noch stärker bevorzugt mindestens 80 % und besonders bevorzugt mindestens 90 %. Die Transparenz ist in der vorliegenden Erfindung so definiert, dass Sonnenstrahlung bei Raumtemperatur die Struktur in dem genannten Ausmaß durchdringt. Genauer kann die Transparenz definiert werden, wenn Licht einer bestimmten Wellenlänge, beispielsweise beim Maximum der Sonnenstrahlung (500 nm), verwendet wird.

### Beleuchtung

Die Integration von Beleuchtungssystemen in sehr flache und dünne Schichten erfolgt bereits bei sogenannten Lichtleiterplatten. Typischerweise wird LED-Licht seitlich an den Stirnseiten eines Lichtwellenleiters (transparente Kunststoffplatte oder Folie) eingekoppelt und mittels Totalreflexion weitergeleitet. An definierten Stellen wird das Licht aus dem Lichtleiter durch im Lichtleitermaterial verteilte streuende Strukturen, feine Oberflächenstrukturen oder feine aufgedruckte Muster ausgekoppelt, wobei eine konstante Leuchtdichte für z.B. die Hinterleuchtung von Bedienelementen eine ungleichmäßige räumliche Verteilung dieser Muster erfordert. Es gibt auch ein mittels Rolle-zu-Rolle-Verfahren (R2R) prozessiertes Dünnschicht-Wellenleitersystem auf Folie, welches für Biegeradien von 2 mm eine Kopplungseffizienz von 25% aufweist. Ein wesentliches Kriterium bei diesem Wellenleitersystem ist die zwischen Kern und Mantel liegende Hochindex-Schicht aus einem anorganischen in einem R2R-Physical Vapour Deposition- (PVD-) Verfahren verdampften Material; dieses ermöglicht eine Wellenleitung mit geringen Verlusten und effizienter Auskopplung über das geprägte Gitter.

In der erfindungsgemäßen Funktionsfolienstruktur kann zumindest ein lichtemittierendes Bauelement angeordnet sein. Bevorzugt ist eine Anzahl von 1 bis 16, stärker bevorzugt 4 bis 8. Das lichtemittierende Bauelement kann ein SMD-Bauteil sein. Die Bauhöhe des lichtemittierenden Elements kann kleiner als 1 mm, bevorzugt kleiner als 300 µm und noch stärker bevorzugt kleiner als 100 µm sein. Es kann sich dabei um eine organische LED oder rein Elektrolumineszenz-Element handeln.

Die geringe Dicke der LEDs minimiert den mechanischen Stress auf die LEDs während der abschließenden Verformung der Foliensensortaste.

Vorzugsweise sind in die Funktionsfolienstruktur mehr als ein lichtemittierendes Element integriert, wobei die Anordnung dieser Elemente symmetrisch oder asymmetrisch in Bezug auf die Form des zumindest einen Sensors sein kann.

Der Abstand der LEDs zum aktiven Bereich des zumindest einen Sensors kann 0,1 cm bis 10 cm, bevorzugt 0,2 bis 1 cm sein.

Das Licht des lichtemittierenden Elementes kann über zumindest einen Wellenleiter in die Sensortaste eingekoppelt sein. Der Wellenleiter kann zumindest ein einlaminiertes POF (plastic optical fiber) enthalten. POFs sind Lichtwellenleiter aus Kunststoff, die primär für die Datenübertragung eingesetzt werden, in Form von Seitenlichtfasern aber auch in der (indirekten) Beleuchtung zum Einsatz kommen.

Der Wellenleiter kann aus Strukturen bestehen, die in ein vorzugsweise transparentes, vorzugsweise flexibles und vorzugsweise dehnbares Polymermaterial mit im Vergleich zum Foliensubstrat erhöhtem Brechungsindex eingebracht werden.

Das Licht wird von den LEDs in alle Richtungen emittiert. Wahlweise kann über der Sensortaste, den LEDs und den Vorwiderständen eine lichtstreuende Klebefolie Diese Streufolie dient einerseits der Rückstreuung und Homogenisierung des Lichts in Richtung Sensortaste und andererseits einem Schutz der diskreten Bauelemente (LEDs, Widerstände). Wahlweise kann ein absorbierender Lack über den LEDs aufgebracht werden, bevorzugt auf der Foliensubstratrückseite, der den Lichtdurchtritt an Stellen außerhalb der Sensortaste verhindern soll. Dadurch kann eine relativ homogene, helle und kontrastreiche Sensortastenbeleuchtung realisiert werden. Das lichtemittierende Element kann beispielsweise mit einer schwarzen, nichttransparenten und nicht-leitenden Dekorfarbe überzogen sein.

Die Funktionsfolienstruktur kann einen Array von lichtemittierenden Elementen umfassen.

### Herstellungsverfahren

Die erfindungsgemäße Funktionsfolienstruktur kann in einem Verfahren hergestellt werden, das folgende Schritte umfasst:
(a) das Bereitstellen einer Funktionsfolie, umfassend ein Foliensubstrat und eine darauf angeordnete Sensoreinheit, die einen Sensor und einen damit verbundenen Leiter aufweist, und
(b) das Formen einer Wölbung in der Funktionsfolie in einem Bereich, der den Sensor und den Leiter zumindest teilweise umfasst, wobei zumindest der Leiter gedehnt wird.

Vorzugsweise umfasst Schritt (a) das Bereitstellen des Foliensubstrats, das Bestücken des Foliensubstrats mit dem Sensor, dem Leiter und anderer Elemente sowie das Aufbringen einer Folie auf das bestückte Foliensubstrat zur Herstellung der Funktionsfolie umfasst.

Erfindungsgemäß erfolgt als erster Schritt das Aufbringen des Sensors und des Leiters auf das Foliensubstrat und das Formen der Funktionsfolienstruktur als zweiter Schritt. Vorzugsweise wird die Funktionsfolie im ersten Schritt auch mit anderen Elementen, wie SMD-Bauteilen, bestückt und mit einer Folie überzogen. Es ist jedoch anzumerken, dass mindestens einer dieser weiteren Schritte auch nach dem Verformen durchgeführt werden kann.

Die erfindungsgemäße Funktionsfolienstruktur kann in einem Verfahren hergestellt werden, bei dem in einem ersten Satz an Verfahrensschritten alle elektrischen, sensorischen und elektrooptischen Funktionen auf einem flachen Folienverbund realisiert werden und in einem zweiten Satz an Schritten dieser mit Funktionen versehene Folienverbund dreidimensional verformt wird.

Der erste Satz an Schritten kann die Herstellung des Folienverbundes, des als Sandwich aufgebauten Sensors, der Leiterbahnen, die Bestückung mit SMD-Bauteilen und ihre Fixierung sowie die Herstellung des gesamten Laminats umfassen.

Der zweite Satz an Schritten kann den Zuschnitt des Verbundes auf das Verformungswerkzeug und die dreidimensionale Verformung umfassen.

In einer Ausführungsform wird der Folienverbund mittels eines Nasskaschiervorgangs in einem Rolle-zu-Rolle-Verfahren hergestellt Der Schichtaufbau der Sensortaste, umfassend eine Grundelektrode, eine ferroelektrische Schicht und eine Deckelektrode, kann mittels Siebdrucks oder Gravurdruck mit dazwischen liegenden Ausheizschritten erfolgen.

Ebenso können die Leiterbahnen mittels Siebdrucks und einem nachfolgenden Ausheizschritt aufgebracht werden. Die Ausheiztemperatur beträgt in einer Ausführungsform maximal 200°, bevorzugt max 100 °C. Vor der Aufbringung der Leiterbahnen kann eine Carbonschicht an den Kontaktstellen zwischen Deckelektrode und Leiterbahn aufgebracht werden. Diese Carbonschicht dient als Diffusionsbarriere und kann im Siebdruck aufgebracht werden.

Wichtig für die Herstellung der erfindungsgemäßen Funktionsfolienstruktur ist, dass die Prozesstemperatur einen gewissen Wert nicht übersteigt. Sie liegt vorzugsweise bei unter 200 °C, stärker bevorzugt bei unter 150°, damit die Eigenschaften der Sensormaterialien erhalten bleibenkönnen und sich die Folie nicht verformt.

Die Auftragung eines leitfähigen Klebers, der beispielsweise zum Befestigen der SMD-Bauteile eingesetzt wird, kann mittels Schablonendrucks erfolgen. Der Kleber kann ein isotrop leitfähiger Kleber sein. Er kann auf AgKontaktpads aufgebracht werden.

Die nach einem Bedruckvorgang erhaltene Folie kann als bedruckte Folie bezeichnet werden.

Die genannten anderen Elemente, die in Schritt (a) aufgebracht werden können, können SMD-Bauteile sein.

Die Bestückung der SMD-Bauteile kann in einer automatischen oder halbautomatischen Pick&Place-Maschine mit einem nachfolgenden Ausheizschritt des Klebers erfolgen.

Die nach einem Bestückungsvorgang erhaltene Folie kann als bestückte Folie bezeichnet werden.

Die SMD-Bauteile können nach der Bestückung in einem Dispenser mit Fixierlack geschützt und fixiert werden.

Das in Schritt (a) genannte Aufbringen einer Folie dient dem Schutz der Bauteile auf dem Foliensubstrat. Dieses Aufbringen kann eine thermische Lamination mit einer Schmelzklebefolie sein.

In einer Ausführungsform wird die gesamte ungeformte Funktionsfolie durch thermische Lamination mit einer lichtstreuenden Schmelzklebefolie nochmals abgedeckt und dadurch geschützt.

Die nach einem Laminiervorgang erhaltene Folie kann als laminierte Folie bezeichnet werden.

Die erfindungsgemäße Funktionsfolienstruktur kann vor dem Formen, also vor dem Bilden der Wölbung, als ungeformte Funktionsfolie oder einfach nur als Funktionsfolie bezeichnet werden.

Nach den Druckschritten, der Bestückung und Fixierung der Bauteile kann die elektrische Aktivierung (=Polung) der ferroelektrischen Schicht erfolgen. Dabei werden die Dipole der Nanokristallite in der ferroelektrischen Schicht durch Polung in einem Hochspannungsfeld mit typischen Polungsfeldstärken von 80 bis 200 MV/m ausgerichtet, wodurch eine makroskopische Polarisation normal zu den Elektrodenflächen entsteht und bei mechanischer oder thermischer Anregung der Sensortaste durch den piezo- oder pyroelektrischen Effekt Ladungen erzeugt werden. Nach der Polung kann durch Auswertung der Hysteresekurven die remanente Polarisation bestimmt werden, welche als Qualitätskriterium für die Funktionalität jedes Sensorpixels herangezogen wird.

Wie vorstehend bereits erwähnt wurde, können im erfindungsgemäßen Verfahren im ersten Schritt das Aufbringen des Sensors und des Leiters auf das Foliensubstrat sowie das Bestücken mit anderen Elementen, das Laminieren und andere zusätzliche Schritte erfolgen.

Mindestens einer dieser zusätzlichen Schritte kann jedoch auch nach dem Verformen durchgeführt werden. Beispielsweise kann das Bestücken mit den anderen Elementen oder das Schutzlaminieren nach dem Verformen erfolgen. Weitere Beispiele sind das Aufbringen eines absorbierenden Lacks oder einer Dekorfarbe sowie das Aufbringen eines Spritzgusses auf die Rückseite der Struktur. Das Durchführen dieser Schritte nach dem Verformen kann den Vorteil haben, dass auch Materialien eingesetzt werden können, welche die erforderliche Dehnbarkeit beim Verformen nicht aufweisen. Auf diese Weise kann die Bandbreite der einsetzbaren Materialien erweitert werden.

Die Funktionsfolie, die vorzugsweise fertig bedruckt, bestückt, gepolt, laminiert und zugeschnitten ist, kann in einem Hochdruckformungsprozess gegen ein Werkzeug dreidimensional verformt werden. Der Verformungsprozess kann unter einem Druck von bis zu 160 bar und bei einer Temperatur von 140 °C und dauert ca. 1 min unter Bildung einer Funktionsfolienstruktur erfolgen. Die maximale Dehnung bei der Verformung im Vergleich zum nicht oder einem weniger verformten Bereich beträgt mindestens 5 %, mindestens 10 %, mindestens 20 % oder mindestens 30 %.

Die ungeformte Funktionsfolie, die bedruckt, bestückt und laminiert sein kann, kann auf ein Verformungswerkzeug zugeschnitten werden. Die dreidimensionale Verformung der ggf. bedruckten, bestückten, laminierten und zugeschnittenen Funktionsfolie kann durch einen Hochdruckformungsprozess gegen ein geeignetes Werkzeug erfolgen. In diesem Prozess ist die Maximaltemperatur vorzugsweise 300 °C, stärker bevorzugt 200 °C und der Maximaldruck vorzugsweise 400 bar, stärker bevorzugt 300 bar. Die dreidimensionale Verformung der Funktionsfolie kann durch einen Tiefziehprozess gegen ein geeignetes Werkzeug erfolgen, so dass die erfindungsgemäße Funktionsfolienstruktur erhalten wird.

Nach dem Verformen kann auf die Rückseite der Funktionsfolienstruktur ein Spritzguss appliziert werden. Dadurch kann dem Bauteil noch mehr Formstabilität verliehen werden. Es muss aber darauf geachtet werden, dass unterhalb der Tastenbereiche genügend mechanische Flexibilität übrigbleibt. Erreicht werden kann diese z.B. durch gezielten Einschluss von Luftblasen.

### Beispiele

Die vorliegende Erfindung wird anhand der nachfolgenden Beispiele weiter veranschaulicht.

### Beispiel 1

Es wurden Sensortasten mit Durchmessern von 10 mm, 15 mm und 20 mm auf einem thermoplastisch verformbaren Foliensubstrat (PMMA-Folie, Dicke: 175 um) realisiert. Die runden Tasten bestanden aus hinreichend transparenten Materialien in Sandwichbauweise mit einer Grundelektrodenschicht, einer ferroelektrischen Sensorschicht und einer Deckelektrodenschicht. Die elektrische Kontaktierung nach außen erfolgte über ringförmige Leiterbahnen. Für die Hinterleuchtung wurden LED-Lichtquellen außerhalb des eigentlichen Tastbereichs angebracht. Die Integration der LEDs direkt neben dem Sensorbereich erforderte eine sehr kleine Bauform der LEDs. Diese wurden durch Pico-LEDs (SMD-Bauteile) mit sehr kleinen Dimensionen (1 mm x 0,6 mm) und einer geringen Dicke von 0,2 mm realisiert. Die Ausleuchtung der Sensortasten wurde vorab anhand optischer Simulationen mit einem kommerziellen Ray-Tracing Tool (OpticStudio) untersucht. Ausgehend von den Simulationen wurden eine ausreichende Anzahl Pico-LEDs und eine äquivalente Anzahl von Vorwiderständen außerhalb des Tastenberührungsbereiches angebracht.

Die Herstellung erfolgte wie folgt: Erst wurden die drucksensitiven Bereiche der Sensortasten in Sandwichbauweise, dann die Vorwiderstände (1 Vorwiderstand pro LED) und schließlich die Leiterbahnen direkt auf die PMMA-Folie gedruckt. Die Grundelektroden der Sensortaste aus PEDOT:PSS wurden mittels Siebdruckverfahrens aufgebracht (Schichtdicke der Elektroden ca. 1 um) und anschließend bei 100°C ausgeheizt, um enthaltene Lösungsmittel abzuziehen. PEDOT:PSS bildet gut leitfähige, semitransparente sowie hinreichend glatte und dadurch für ein weiteres Bedrucken geeignete Elektroden. Danach wurde die ferroelektrische Sensorschicht aus PVDF-TrFE Copolymer (P(VDF:TrFE)=70:30 mit Schichtdicke ca. 10 um) ebenfalls mittels Siebdrucks aufgebracht, wobei diese Schicht die Grundelektroden vollständig überlappte. Anschließend wurde die Schicht zur Entfernung des Lösungsmittels (z.B. modifiziertes γ-Butyrolacton) bei 100 Grad ausgeheizt. Mittels Siebdrucks wurden die Leiterbahnen aus Silber (Breite ca. 1mm) gedruckt, um die elektrische Anbindung nach außen zu ermöglichen, nämlich zur Spannungsversorgung der LEDs und zu einer Auswerte-Elektronik (z.B. Transimpedanzverstärker, Ladungsverstärker) für die Verstärkung und Verarbeitung der durch den Fingerdruck erzeugten Signale. Des Weiteren wurden mittels Siebdruck Deckelektroden aus PEDOT-PSS (Schichtdicke der Elektroden ca. 1 um) aufgedruckt und ausgeheizt (100°C), wobei ihre laterale Ausdehnung bevorzugt etwas kleiner als jene der Grundelektroden ist. Nach dem Siebdruck der Vorwiderstände aus Carbon (und Ausheizen bei 100°C über 15 min) wurden als letzter Herstellungsschritt die Pico-LEDs per Hand auf die Folie leitfähig geklebt, wobei ein modifizierter und mit Ag-Nanopartikeln gefüllter Acrylatkleber verwendet wurde.

Im Anschluss wurde die semikristalline ferroelektrische Polymerschicht in einem elektrischen Feld gepolt. Der elektrische Polungsschritt erfolgte mittels Hysteresepolung mit typischen Polungsfeldstärken von 80 bis 200 MV/m.

Nach Integration aller Funktionalitäten auf der PMMA-Folie (Sensortaste und Beleuchtung) und elektrischer Polung wurde die Funktionsfolie in einem Vakuum- und Temperatur-unterstützten Prozess dreidimensional umgeformt. Die dreidimensionale Form entsprach einer Kugelkalotte mit einer maximalen Dehnung von ca. 40%.

### Beispiel 2

In diesem Beispiel wird ein Verfahren zur Herstellung einer hinterleuchteten druck- oder temperatursensitiven Foliensensortaste, die eine dreidimensionale Form aufweist (siehe Figur 2).

Zunächst wurde ein Folienverbund hergestellt. Das flächige Verbinden der Funktionsfolie (z.B. PEN) und der Trägerfolie (z.B. ABS) erfolgte mittels eines Nasskaschiervorgangs in einem Rolle-zu-Rolle-Verfahren. Beim Kaschiervorgang wurde zunächst ein flüssiger Kaschierkleber auf eine der beiden Folien aufgetragen, vorgetrocknet und die so beschichtete Folie anschließend unter Einwirkung von Druck und/oder Temperatur mit der anderen Folie verbunden.

Danach wurde die Foliensensortaste hergestellt. Die einzelnen Schichten der Foliensensortaste (Sensorsandwich, Leiterbahnen) und die Dekorfarbe wurden mittels additiven Siebdruckverfahrens inkl. Zwischentrocknung durch eine Maske (Sieb/Schablone) auf einen vorgeschnittenen Folienverbund (z.B. PEN/ABS) strukturiert aufgebracht. Die Druckreihenfolge war wie folgt: Auf der bedruckbaren PEN-Seite des Folienverbundes wurde erst eine PEDOT:PSS Schicht für die Grundelektroden (Schichtdicke 1 µm) und dann die ferroelektrische Sensorschicht (Schichtdicke 10 µm) gedruckt, dann wurden die PEDOT:PSS Deckelektroden (Schichtdicke 1 µm), dann eine Carbonschicht (Schichtdicke 1-3 µm) als leitende Diffusionssperre und schließlich elektrische Leiterbahnen (z.B. aus Silber) (Breite 2 mm) für die Außenkontaktierung aufgebracht. Außerdem wurde in allen Bereichen außerhalb des semitransparenten Tastenbereichs (siehe Fig. 2) eine schwarze und daher gut absorbierende, nicht leitende Dekorfarbe/Konturfarbe aufgedruckt. Zwischen den Druckschritten wurde bei 60-65°C ausgeheizt.

Danach wurde der Kleber aufgetragen und die SMD-Bestückung durchgeführt. Mittels Schablone wurde ein isotrop leitfähiger Kleber (MG-8331S, bzw. modifizierter mit Ag-Nanopartikel gefüllter Acrylatkleber) strukturiert aufgetragen. In die nasse Klebermasse wurden im Anschluss die SMD Bauteile (LEDs und Vorwiderstände) per Pick&Place-Automat positioniert. Die elektrische Kontaktierung der Bauteile an die Folie erfolgte durch Aushärtung des Klebers in einem Trockenschrank bei 100°C mit einer Verweildauer von 15 Minuten.

Zur Verstärkung der Haftungseigenschaften der SMD-Bauteile auf der Folie wurden diese zusätzlich lokal mit einem niederviskosen Lack fixiert.

Danach wurde die elektrische Aktivierung (=Polung) des ferroelektrischen Schicht der Sandwich-Sensortaste durchgeführt.

Nach der Polung wurde auf die Folienoberseite eine Schmelzklebefolie (Schmelzklebstoffe auf Basis PA, PE, APAO, EVAC, TPE-E, TPE-U, TPE-A) laminiert. Danach wurde mit einem Lasercutter ein Zuschnitt der Funktionsfolien auf das Verformungswerkzeug durchgeführt.

Die zugeschnittene Funktionsfolie wurde in einem Hochdruckformungsprozess gegen ein Werkzeug dreidimensional verformt. Der Verformungsprozess erfolgte unter einem Druck von bis zu 160 bar und bei einer Temperatur von 140 °C und dauerte ca. 1 min. Die maximale Dehnung bei der Verformung betrug ca. 65%.

### Bezugszeichenliste

- 1: Foliensubstrat
- 2: Sensorsandwich
- 3: Leiterbahn(en)
- 4: LED
- 5: Vorwiderstand
- 6: Folienverbund
- 7: Streuschicht
- 8: Konturfarbe

## Patentansprüche

1. Funktionsfolienstruktur mit einer Wölbung, erhältlich durch ein Verfahren, das folgende Schritte umfasst:
(a) das Bereitstellen einer Funktionsfolie, enthaltend ein Foliensubstrat und eine darauf angeordnete Sensoreinheit, die einen auf Druck- und/oder Temperaturänderung reagierenden Sensor und einen damit verbundenen Leiter aufweist, wobei der Sensor ein Schichtsensor ist, der eine erste elektrisch leitfähige Schicht, eine Schicht aus einem ferroelektrischen Polymer und eine zweite elektrisch leitfähige Schicht in dieser Reihenfolge enthält, und
(b) das Formen der Wölbung in der Funktionsfolie in einem Bereich, der den Sensor und den Leiter zumindest teilweise enthält, wobei der Leiter und der Sensor gedehnt werden.

2. Funktionsfolienstruktur nach Anspruch 1, wobei die ferroelektrische Polymerschicht, die elektrisch leitfähigen Schichten und der Leiter druckbar sind.

3. Funktionsfolienstruktur nach einem der vorstehenden Ansprüche, wobei der Bereich mit dem Sensor dicker als der dazu benachbarte Bereich ist.

4. Funktionsfolienstruktur nach einem der vorstehenden Ansprüche, die selbsttragend ist.

5. Funktionsfolienstruktur nach einem der vorstehenden Ansprüche, wobei die Wölbung einen Bereich mit einer Dehnung von mindestens 20 % im Vergleich zu dem nicht gewölbten Bereich aufweist.

6. Funktionsfolienstruktur nach einem der vorstehenden Ansprüche, wobei auf dem Foliensubstrat eine Bauteilebefestigungsstruktur aufgebracht ist, die einen leitfähigen Kleber, elektrische Bauteile und einen Lack in dieser Reihenfolge enthält.

7. Funktionsfolienstruktur nach Anspruch 6, enthaltend eine Klebefolie über der Bauteilebefestigungsstruktur oder der Bauteilebefestigungsstruktur und dem Schichtsensor zum Kleben an das Foliensubstrat.

8. Funktionsfolienstruktur nach einem der vorstehenden Ansprüche, die ein lichtemittierendes Element enthält, das über einen Wellenleiter so mit dem Sensor gekoppelt ist, dass es den Sensor zum Leuchten bringen kann.

9. Funktionsfolienstruktur mit einer Funktionsfolie, die ein Foliensubstrat und eine darauf angeordnete Sensoreinheit, die einen auf Druck- und/oder Temperaturänderung reagierenden Sensor und einen damit verbundenen Leiter aufweist, sowie eine Wölbung in einem Bereich beinhaltet, der den Sensor und den Leiter zumindest teilweise enthält, wobei der Leiter und der Sensor gedehnt sind.

10. Verfahren zum Herstellen einer Funktionsfolienstruktur nach einem der vorstehenden Ansprüche, das folgende Schritte umfasst:
(a) das Bereitstellen einer Funktionsfolie, enthaltend ein Foliensubstrat und eine darauf angeordnete Sensoreinheit, die einen Sensor und einen damit verbundenen Leiter aufweist, und
(b) das Formen einer Wölbung in der Funktionsfolie in einem Bereich, der den Sensor und den Leiter zumindest teilweise enthält, wobei der Leiter und der Sensor gedehnt werden.

11. Verfahren nach Anspruch 10, wobei Schritt (a) das Bereitstellen des Foliensubstrats, das Bestücken des Foliensubstrats mit dem Sensor, dem Leiter und anderer Elemente sowie das Aufbringen einer Folie auf das bestückte Foliensubstrat zur Herstellung der Funktionsfolie umfasst.

12. Verfahren nach Anspruch 10 oder 11, wobei der Sensor einen Schichtaufbau aufweist, die anderen Elemente SMD-Bauteile umfassen und das Aufbringen der Folie auf das bestückte Foliensubstrat eine thermische Lamination mit einer Schmelzklebefolie ist.

13. Verfahren nach Anspruch 11 oder 12, wobei die Herstellung des Schichtaufbaus des Sensors mittels Siebdrucks oder Gravurdrucks mit dazwischenliegenden Ausheizschritten durchgeführt wird und/oder der Leiter mittels Siebdrucks und einem nachfolgenden Ausheizschritt aufgebracht wird.

14. Verfahren nach einem der Ansprüche 10 bis 13, wobei Schritt (b) durch ein Hochdruckverformungsverfahren oder Tiefziehverfahren gegen ein geeignetes Werkzeug erfolgt.

## Claims

1. A functional film structure having a curvature and being obtainable by a process comprising the steps of:
(a) providing a functional film comprising a film substrate and a sensor unit that is disposed on the substrate and has a pressure and/or temperature change responsive sensor and a conductor connected thereto, wherein the sensor is a layered sensor comprising, in the indicated order, a first electrically conductive layer, a layer of a ferroelectric polymer and a second electrically conductive layer; and
(b) forming the curvature in the functional film in a section at least partially comprising the sensor and the conductor, thereby stretching the conductor and the sensor.

2. The functional film structure to claim 1, wherein the ferroelectric polymer layer, the electrically conductive layers and the conductor are printable.

3. The functional film structure according to any one of the preceding claims, wherein the section containing the sensor is thicker than the section adjacent thereto.

4. The functional film structure according to any one of the preceding claims, which is self-supporting.

5. The functional film structure according to any one of the preceding claims, wherein the curvature contains a section being stretched by at least 20 % in comparison to the non-curved section.

6. The functional film structure according to any one of the preceding claims, wherein a component mounting structure comprising, in the indicated order, a conductive adhesive, electrical components and a lacquer is applied to the film substrate.

7. The functional film structure according to claim 6, comprising an adhesive film over the component mounting structure or the component mounting structure and the layer sensor for bonding to the film substrate.

8. The functional film structure according to any one of the preceding claims, comprising a light-emitting element that is coupled to the sensor via a waveguide such that it can cause the sensor to illuminate.

9. A functional film structure having a functional film comprising a film substrate and a sensor unit that is disposed on the substrate and has a pressure and/or temperature change responsive sensor and a conductor connected thereto, wherein the functional film further comprises a curvature in a section at least partially comprising the sensor and the conductor, wherein the conductor and the sensor are stretched.

10. A method of manufacturing a functional film structure according to any one of the preceding claims, comprising the steps of:
(a) providing a functional film comprising a film substrate and a sensor unit disposed thereon, the sensor unit having a sensor and a conductor connected thereto; and
(b) forming a curvature in the functional film in a section at least partially comprising the sensor and the conductor, thereby stretching the conductor and the sensor.

11. The method of claim 10, wherein step (a) comprises providing the film substrate, equipping the film substrate with the sensor, the conductor and other elements, and applying a film to the equipped film substrate to produce the functional film.

12. The method according to claim 10 or 11, wherein the sensor has a layered structure, the other elements comprise SMD components and the application of the film to the equipped film substrate is a thermal lamination with a hot-melt adhesive film.

13. The method according to claim 11 or 12, wherein the production of the layer structure of the sensor is carried out by means of screen printing or engraving printing with intermediate baking steps and/or the conductor is applied by means of screen printing and a subsequent baking step.

14. The process according to any one of claims 10 to 13, wherein step (b) is performed by a high-pressure forming process or deep-drawing process against a suitable tool.

## Revendications

1. Structure de feuille fonctionnelle avec un bombement, qui peut être obtenue par un procédé comprenant les étapes suivantes :
(a) la fourniture d'une feuille fonctionnelle, contenant un substrat de feuille et une unité de détection disposée sur celui-ci et qui présente un capteur réagissant à des modifications de pression et/ou de température ainsi qu'un conducteur relié à celui-ci, dans laquelle le capteur est un capteur à couches qui contient dans cet ordre une première couche électriquement conductrice, une couche de polymère ferroélectrique et une seconde couche électriquement conductrice, et
(b) le formage du bombement dans la feuille fonctionnelle dans une zone qui contient au moins partiellement le capteur et le conducteur, dans laquelle le conducteur et le capteur sont étendus.

2. Structure de feuille fonctionnelle selon la revendication 1, dans laquelle la couche de polymère ferroélectrique, les couches électriquement conductrices et le conducteur peuvent être mis sous pression.

3. Structure de feuille fonctionnelle selon une des revendications précédentes, dans laquelle la zone avec le capteur est plus épaisse que la zone adjacente à celui-ci.

4. Structure de feuille fonctionnelle selon une des revendications précédentes, laquelle est autoporteuse.

5. Structure de feuille fonctionnelle selon une des revendications précédentes, dans laquelle le bombement présente une zone avec une dilatation d'au moins 20 % par rapport à la zone non bombée.

6. Structure de feuille fonctionnelle selon une des revendications précédentes, dans laquelle sur le substrat de feuille est appliquée une structure de fixation de composants qui contient dans cet ordre une colle conductrice, des composants électriques et une laque.

7. Structure de feuille fonctionnelle selon la revendication 6, contenant une feuille de collage au-dessus de la structure de fixation de composants ou de la structure de fixation de composants et du capteur à couches pour le collage sur le substrat de feuille.

8. Structure de feuille fonctionnelle selon une des revendications précédentes, laquelle contient un élément électroluminescent qui est couplé au capteur par le biais d'un guide d'ondes de manière à pouvoir éclairer le capteur.

9. Structure de feuille fonctionnelle avec une feuille fonctionnelle, laquelle présente un substrat de feuille et une unité de détection disposée sur celui-ci et qui présente un capteur qui réagit au changement de pression et/ou de température ainsi qu'un conducteur relié à celui-ci, et comporte un bombement dans une zone qui contient au moins partiellement le capteur et le conducteur, dans laquelle le conducteur et le capteur sont étendus.

10. Procédé destiné à fabriquer une structure de feuille fonctionnelle selon une des revendications précédentes et qui comprend les étapes suivantes :
(a) la fourniture d'une feuille fonctionnelle, contenant un substrat de feuille et une unité de détection disposée sur celui-ci et qui présente un capteur et un conducteur relié à celui-ci, et
(b) le formage d'un bombement dans la feuille fonctionnelle dans une zone qui contient au moins partiellement le capteur et le conducteur, dans lequel le conducteur et le capteur sont étendus.

11. Procédé selon la revendication 10, dans lequel l'étape (a) comprend la fourniture du substrat de feuille, l'équipement du substrat de feuille avec le capteur, le conducteur et d'autres éléments ainsi que l'application d'une feuille sur le substrat de feuille équipé pour la fabrication de la feuille fonctionnelle.

12. Procédé selon la revendication 10 ou 11, dans lequel le capteur présente une structure de couches, les autres éléments comprennent des composants SMD et l'application de la feuille sur le substrat de feuille équipé est une lamination thermique avec une feuille de colle thermofusible.

13. Procédé selon la revendication 11 ou 12, dans lequel la fabrication de la structure de couches du capteur est réalisée à l'aide d'une sérigraphie ou d'une gravure avec des étapes de chauffage intermédiaires et/ou le conducteur est appliqué à l'aide d'une sérigraphie et d'une étape de chauffage ultérieure.

14. Procédé selon une des revendications 10 à 13, dans lequel l'étape (b) se fait par un processus de déformation sous haute pression ou par un processus d'emboutissage contre un outil approprié.
